(19) Europäisches Patentamt
European Patent Office
Office européen des brevets

(11) EP 0 343 792 B1

(12) EUROPEAN PATENT SPECIFICATION

(45) Date of publication and mention
of the grant of the patent:
14.08.1996 Bulletin 1996/33

(51) Int Cl.⁶: H03H 17/02, G10L 3/02

(21) Application number: 89304198.8

(22) Date of filing: 27.04.1989

(54) **A noise elimination method**

Geräuschunterdrückungsverfahren

Procédé d'élimination de bruit

(84) Designated Contracting States:
AT BE CH DE ES FR GB GR IT LI LU NL SE

(30) Priority: 26.05.1988 FI 882494

(43) Date of publication of application:
29.11.1989 Bulletin 1989/48

(73) Proprietor: NOKIA MOBILE PHONES LTD.
SF-24101 Salo (FI)

(72) Inventors:
• Renfors, Markku Kalevi
SF-33800 Tampere (FI)
• Neuvo, Yrjö Aunus Olavi
SF-33720 Tampere (FI)
• Mäkinen, Jorma Juhani
SF-33720 Tampere (FI)
• Tenhunen, Aarne Hannu Kristian
SF-33720 Tampere (FI)
• Rapeli, Juha
SF-90100 Oulo (FI)

(74) Representative: Frain, Timothy John et al
Patent Department
Nokia Mobile Phones
St Georges Court
St Georges Road
Camberley, Surrey GU15 3QZ (GB)

(56) References cited:
• IEEE INTERNATIONAL CONFERENCE ON ACOUSTICS, SPEECH AND SIGNAL PROCESSING, ICASSP'82, Paris, 3rd - 5th May 1982, vol. 1, pages 168-171, IEEE, New York, US; G. DOBLINGER:""Optimum" filter for speech enhancement using integrated digital signal processors"
• THE BELL SYSTEM TECHNICAL JOURNAL, vol. 60, no. 8, October 1981, pages 1847-1859, American Telephone & Telegraph Co., New York, US; M.M. SONDHI et al.: "Improving the quality of a noisy speech signal"
• IEEE INTERNATIONAL CONFERENCE ON ACOUSTICS, SPEECH, AND SIGNAL PROCESSING, ICASSP'84, San Diego, CA, 19th - 21st March 1984, vol. 1, pages 12B.1.-12B.1.4, IEEE, New York, US; D. PELLONI et al.: "Enhancement of audio based on digital techniques"

## Description

The invention relates to a method for eliminating noise in an information channel by filtering a noisy signal coming through the channel.

Disturbing noise often appears in an information channel, specifically a communications channel, such as a mobile radio telephone channel. The noise may be due both to the connection and to noise around the actual source, the speaker. For example, the background noise in an automobile is heard as noise in the background of a telephone call spoken over a mobile radio telephone.

To eliminate disturbances and noise it is possible to use a plurality of methods. For example, by means of a high-pass filter it is possible to eliminate noise at low frequencies. However, in a signal coming to a mobile telephone from stations, the noise is within the same frequency range as is the speech signal, and so a situation is arrived at in which speech is also eliminated if attempts are made to eliminate the noise.

Endeavors have been made to eliminate the effects of background noise, when speaking from automobiles, by using, for example, a second microphone. Only noise is received in this microphone placed elsewhere in the automobile, and this noise can be eliminated from the entire signal before the speech signal is transmitted further from the telephone. Only slight improvement of the signal to noise ratio has been achieved by this method, since suitable placing of the microphone is difficult.

The object of the present invention is to eliminate the problems appearing in the methods described above and to provide a method by which it is possible to eliminate noise in an information channel without suppressing the speech signal.

According to a first aspect of the invention there is provided a method
for suppressing noise in an information channel, comprising filtering a noisy information signal coming through the channel so that the frequency band of the channel is divided into sub-bands, comparing in each sub-band a noisy information signal level with a reference level, defining a noisy information signal level equal to or less than the reference level as noise and suppressing said noisy information signal in accordance with a given characteristic curve to form a suppressed signal and summating the suppressed signals in each of the sub-bands, characterised in that the suppression of said noisy information signal has a maximum value such that when the noisy information signal level in a given sub-band is equal to or less than the reference level, there is non-zero gain in the given sub-band.

According to a second aspect of the invention there is provided apparatus for suppressing noise in an information channel, comprising filtering means for dividing a noisy information signal input from the information channel into sub-bands, comparing means for each sub-band for comparing a noisy information signal level with a reference level, suppression means for suppressing noisy information signals in respective sub-bands according to a given characteristic curve, to form suppressed noisy information signals, and summation means for summing the suppressed noisy information signals in each of the sub-bands, characterised in that the suppression means operate at a maximum suppression value when the noisy information signal in a given sub-band is equal to or less than the reference level, such that there is non-zero gain in the given sub-band.

Frequency bands containing nothing but noise or a great deal of background noise can in this case be eliminated. This is possible, since a speech signal does not use the entire frequency range all the time.

The invention is described below with the help of an embodiment example, with reference to the accompanying drawing, in which

Figure 1 is a block diagram of the principle of an arrangement with which the method according to the invention is implemented;
Figure 2 is the construction of a four-channel filter bank;
Figure 3 depicts a filter pair consisting of a low-pass filter and a high-pass filter;
Figure 4 is a block diagram of an arrangement with which the suppression of a single channel is controlled;
Figure 5 illustrates the division of a frequency band into sub-bands;
Figure 6 is a characteristic curve determining the amount of signal passage.

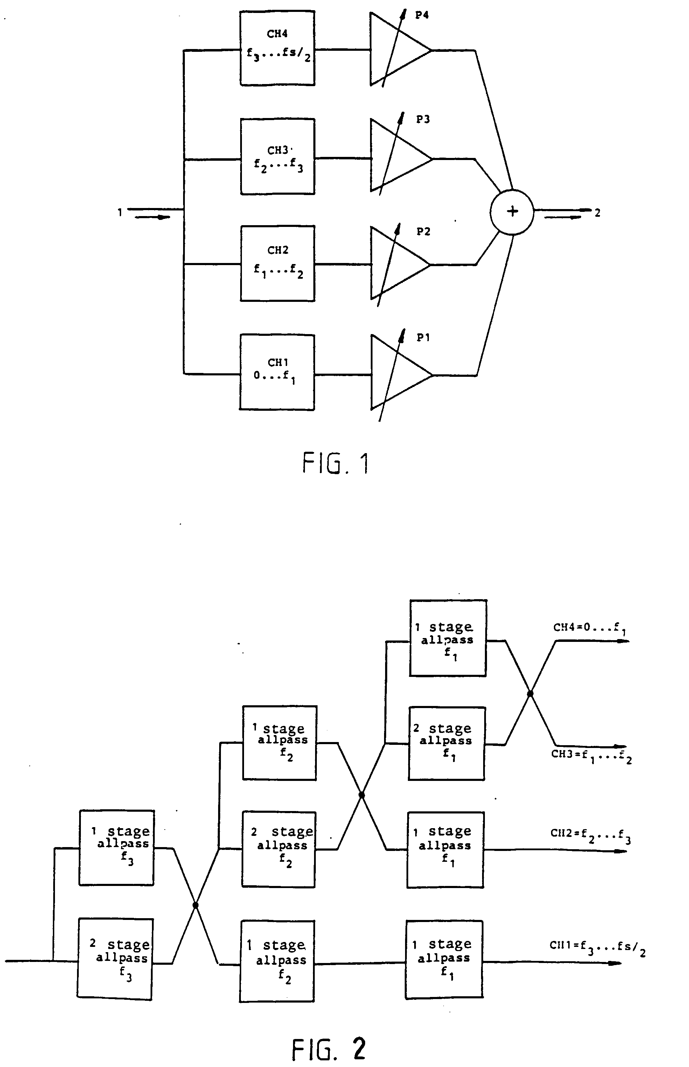

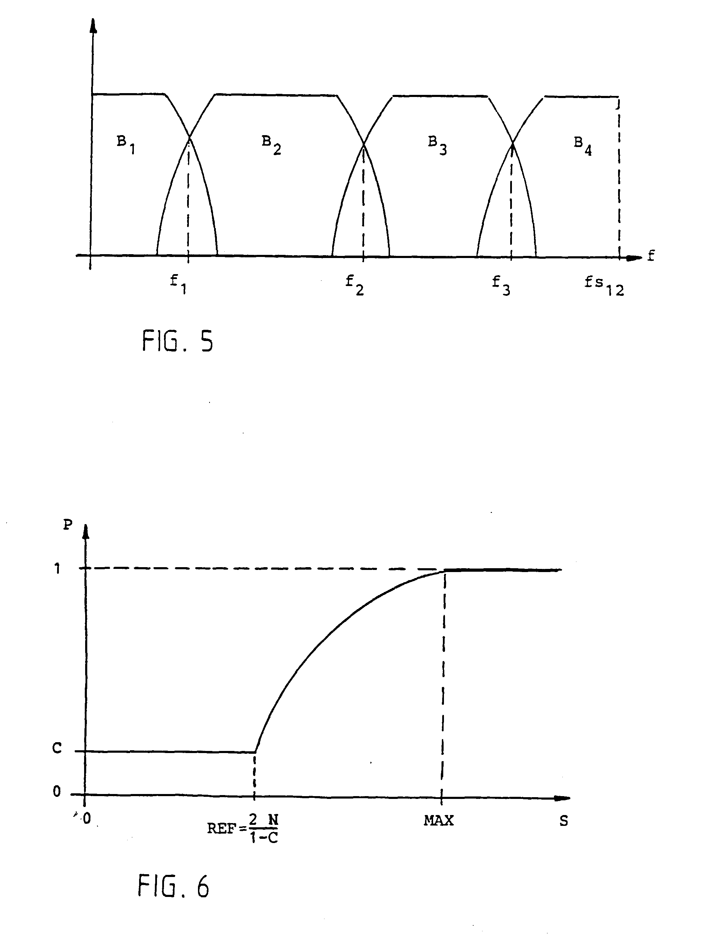

The principle of the implementation of the method is depicted in Figure 1 as a block diagram. A signal 1 is supplied to the filter blocks CH1-CH4, in which the signal is divided into frequency bands B1-B4 (Figure 5). The outputs of the filters are coupled to suppressors P1-P4, by means of which it is possible to eliminate frequency bands which contain nothing but noise. Finally the bands are again summated, and the improved signal 2 is carried further.

The division into frequency bands B1, B2, B3 and Bn is implemented using the all-pass filter construction according to Figure 2. The limit frequencies of the frequency bands are $f_1$, $f_2$, $f_3$.

The transfer function of the all-pass filter of the first stage is

$$A_1 = (a + z^{-1}) / (1 + az^{-1})$$

and respectively the transfer function of the all-pass filter of the second stage is

$$A_2 = (b + cz^{-1} + z^{-2}) / (1 + cz^{-1} + bz^{-2})$$

where coefficients a, b and c are obtained from the formulae

$$a = \sin(\omega/2 - \pi/4) / \sin(\omega/2 + \pi/4)$$

$$b = (a^2 + \alpha) / (1 + \alpha a^2)$$

$$c = (2a(1+\alpha)) / (1 + \alpha a^2)$$

where $\omega = 2\pi f / f_s$ and $\alpha = f_s / 4 f_H$
and $f_H$ = limit frequency of filter
and $f_s$ = sample taking frequency of filter.

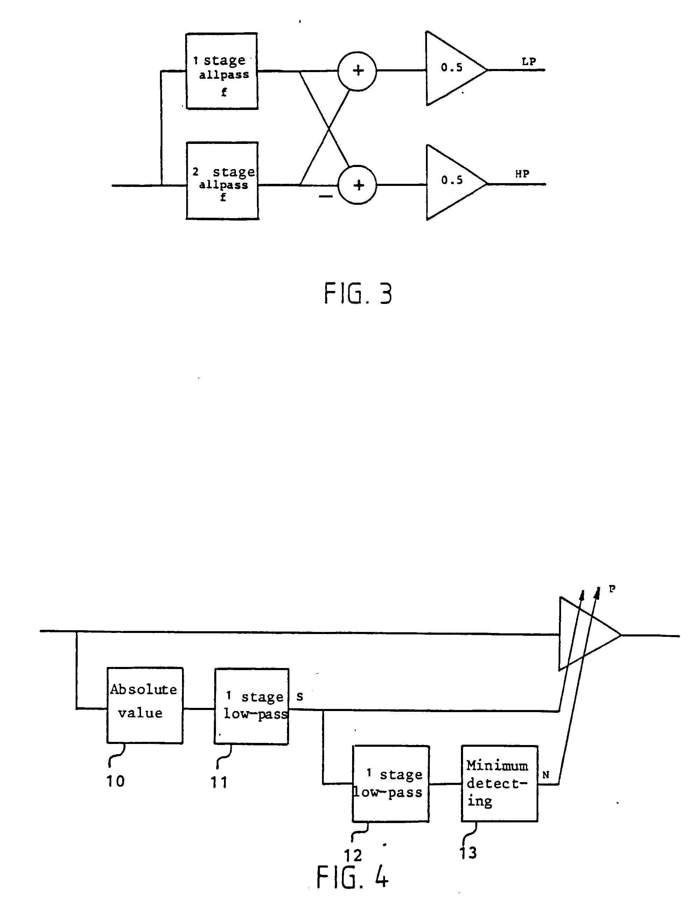

The filters of the first and second stages have been formed into low-pass - high-pass pairs (Figure 3) by means of which the signal is always divided into two frequency bands. Three filter stages are required in order that a division into four frequency bands will occur.

The suppression control depicted in Figure 4 is carried out in each frequency band by setting the amplification of the signal according to the following equation

$$p = \max \{(S\text{-}2N)/S , C\}$$

where

S = signal level
N = noise level
C = constant indicating the maximum suppression of the bands, in practice, for example 0.2.

If there is no signal within the frequency band being examined, the signal level S and the noise level N are approximately equal, and the passing amount of the frequency band is C. If the signal S is substantially greater than the noise level N, the passing amount P attains a value and the signal is not suppressed at all.

The monitoring of the signal level is carried out by rectifying (10) and low-pass filtering (11, 12) the signal of the frequency band.

The low-pass filter 11 can be, for example, the recursive filter of the first stage

$$Y_s(k) = A_s Y_s(k\text{-}1) + (1\text{-}A_s)X_s(k)$$

where

$A_s(k)$ = coefficient
$Y_s(k)$ = output signal
$X_s(k)$ = input signal

The noise level N within each frequency band is detected by further low-pass filtering (12) the signal coming from the level detector and by detecting (13) from this the long-term minimum. Thus it is possible to determine whether the frequency band in question has a constant-value signal (which is noise) or a signal of continually changing value, which can be deemed to be a useful signal. The recursive filter of the first stage may again serve as the low-pass filter

$$Y_n(k) = A_n Y_n(k\text{-}1) + (1\text{-}A_n)X_n(k)$$

where the terms stand for the same as in the previous formula. Referring to Figure 4, $X_n(k) = Y_s(k)$.

The minimum is calculated from the equation

$$N(k) = \min \{Y_n(k), N(k\text{-}1) + \delta\}$$

where $\delta$ = constant representing the maximum increase rate of the noise level N.

Four was chosen as the number of frequency bands in the examples. An increase in their number increases the number of all-pass blocks (quadratically). From the viewpoint of practical implementation, it is hardly worth while increasing the number of bands. In the present application, 3 is a good choice for the number of frequency bands.

The functioning of the method has been verified by practical subjective experiments.

It is evident that the method can be applied using different circuitries. Both analog and digital circuit constructions are usable.

## Claims

1. A method for suppressing noise in an information channel (1),
comprising filtering a noisy information signal coming through the channel so that the frequency band of the channel (1) is divided (CH1-CH4) into sub-bands (B1-B4), comparing in each sub-band (B1-B4) a noisy information signal level (S) with a reference level (Ref), defining a noisy information signal level equal to or less than the reference level (Ref) as noise and suppressing (P1-P4) said noisy information signal in accordance with a given characteristic curve to form a suppressed signal and summating the suppressed signals in each of the sub-bands (B1-B4), characterised in that the suppression of said noisy information signal has a maximum value such that when the noisy information signal level (S) in a given sub-band is equal to or less than the reference level, there is non-zero gain in the given sub-band.

2. A method according to claim 1, wherein, when the noisy information signal level (S) detected on a sub-band exceeds the reference level (Ref) its suppression is inversely proportional to the amount of the excess in accordance with the given characteristic curve, and noisy information signal levels exceeding an upper limit (Max) are substantially unsuppressed.

3. A method according to claim 1, wherein the noisy information signal level (S) to be compared in a given sub-band is formed by rectifying (10) and low-pass filtering (11) the noisy information signal, the reference level (Ref) is formed as the long-term minimum of the noisy information signal level, (N) and the amount of signal gain (P) at any given time is obtained from the formula:

$$P = \max \{(S-2N)/S, C\}$$

where S is the noisy information signal level, N is the long-term minimum of the noisy information signal level and C is a constant indicating the minimum gain of a respective sub-band.

4. A method according to any of the above claims, wherein the information channel comprises a base-frequency speech channel for a communications channel and the frequency band of the channel is divided into four sub-bands (B1-B4).

5. A method according to any of the above claims, wherein the frequency band of the channel is divided into sub-bands (B1-B4) by using an all-pass filter construction.

6. Apparatus for suppressing noise in an information channel (1), comprising filtering means for dividing (CH1-CH4) a noisy information signal input from the information channel into sub-bands (B1-B4), comparing means for each sub-band (B1-B4) for comparing a noisy information signal level (S) with a reference level (Ref), suppression means (P1-P4) for suppressing noisy information signals in respective sub-bands (B1-B4) according to a given characteristic curve, to form suppressed noisy information signals, and summation means for summing the suppressed noisy information signals in each of the sub-bands (B1-B4), characterised in that the suppression means (P1-P4) operate at a maximum suppression value when the noisy information signal in a given sub-band is equal to or less than the reference level, such that there is non-zero gain in the given sub-band.

7. Apparatus according to claim 6, wherein the suppression means (P1-P4) is adapted to suppress noisy information signals in a given sub-band exceeding the reference level (Ref) by an amount which is inversely proportional to the amount by which the noisy information signals exceed said reference level (Ref) and noisy information signal levels (S) exceeding an upper limit (Max) are substantially unsuppressed.

8. Apparatus according to claim 6, wherein there is provided rectifying means (10) and low pass filtering means (11) for forming noisy information signal level (S) for each sub-band, means for determining a long-term minimum of the noisy information signal level (N) for use as the reference level (Ref), and wherein the suppression means (P1-P4) has a gain (P) given by

$$P = \max \{(S-2N)/S, C\}$$

where S is the signal level, N is the long-term minimum of the noisy information signal level, and C is a constant indicating the minimum gain of a respective sub-band.

9. Apparatus according to any of claims 6 to 8, wherein the information channel comprises a base-frequency speech channel for a communication channel and the frequency band of the channel is divided into four sub-bands (B1-B4).

10. Apparatus according to any of claims 6 to 9, wherein there is provided all-pass filter means for dividing a frequency band of the information channel into the sub-bands (B1-B4).

**Patentansprüche**

1. Verfahren zur Rauschunterdrückung in einem Informationskanal (1), bei dem zunächst ein den Kanal durchlaufendes Rauschinformationssignal so gefiltert wird, daß das Frequenzband des Kanals (1) in vier Unterbänder (B1 - B4) aufgeteilt wird (CH1 - CH4), wobei in jedem Unterband (B1 - B4) ein Rauschinformationssignalpegel (S) mit einem Referenzpegel (Ref) verglichen wird, ein Rauschinformationssignalpegel gleich dem oder kleiner als der Referenzpegel (Ref) als Rauschen definiert wird, das Rauschinformationssignal in Übereinstimmung mit einer gegebenen Kennlinie unterdrückt (P1 - P4) wird, um ein unterdrücktes Signal zu erhalten, und wobei ferner die unterdrückten Signale aller Unterbänder (B1 - B4) summiert werden, **dadurch gekennzeichnet,** daß die Unterdrückung des Rauschinformationssignals einen Maximumwert aufweist, so daß dann, wenn der Rauschinformationssignalpegel (S) in einem gegebenen Unterband gleich oder kleiner ist als der Referenzpegel, im gegebenen Unterband eine Verstärkung ungleich Null vorhanden ist.

2. Verfahren nach Anspruch 1, **dadurch gekennzeichnet**, daß dann, wenn der in einem Unterband detektierte Rauschinformationssignalpegel (S) den Referenzpegel (Ref) überschreitet, seine Unterdrückung umgekehrt proportional zur Größe dieser Überschreitung in Übereinstimmung mit einer gegebenen Kennlinie ist, und daß Rauschinformationssignalpegel, die eine obere Grenze (Max) überschreiten, im wesentlichen nicht unterdrückt werden.

3. Verfahren nach Anspruch 1, **dadurch gekennzeichnet,** daß der in einem gegebenen Unterband zu vergleichende Rauschinformationssignalpegel (S) durch Gleichrichtung (10) und Tiefpassfilterung (11) des Rauschinformationssignals erhalten wird, der Referenzpegel (Ref) in Form des Langzeitminimums (N) des Rauschinformationssignalpegels gebildet wird, und die Größe der Signalverstärkung (P) zu irgendeiner gegebenen Zeit anhand der nachfolgenden Formel erhalten wird:

$$P = \max \{(S - 2N) / S, C\},$$

worin S der Rauschinformationssignalpegel, N das Langzeitminimum des Rauschinformationssignalpegels und C eine Konstante sind, die die Minimumverstärkung eines jeweiligen Unterbandes angibt.

4. Verfahren nach einem der vorhergehenden Ansprüche, **dadurch gekennzeichnet,** daß der Informationskanal einen Basisfrequenz-Sprachkanal für einen Kommunikationskanal aufweist und das Frequenzband des Kanals in vier Unterbänder (B1 - B4) unterteilt ist.

5. Verfahren nach irgendeinem der vorhergehenden Ansprüche, **dadurch gekennzeichnet,** daß das Frequenzband des Kanals durch Verwendung einer Allpass-Filterkonstruktion in vier Unterbänder (B1 - B4) unterteilt ist.

6. Vorrichtung zur Rauschunterdrückung in einem Informationskanal (1), mit einer Filtereinrichtung zur Unterteilung (CH1 - CH4) eines vom Informationskanal kommenden Rauschinformationssignaleingangs in vier Unterbänder (B1 - B4), einer Vergleichseinrichtung für jedes Unterband (B1 - B4) zum Vergleich eines Rauschinformationssignalpegels (S) mit einem Referenzpegel (Ref), Unterdrükkungsmitteln (B1 - B4) zur Unterdrückung von Rauschinformationssignalen in den jeweiligen Unterbändern (B1 - B4) in Übereinstimmung mit einer gegebenen Kennlinie, um unterdrückte Rauschinformationssignale zu erhalten, und mit Summiermitteln zur Summierung der unterdrückten Rauschinformationssignale aller Unterbänder (B1 - B4), **dadurch gekennzeichnet,** daß die Unterdrükkungsmittel (P1 - P4) bei einem maximalen Unterdrückungswert arbeiten, wenn das Rauschinformationssignal in einem gegebenen Unterband gleich oder kleiner ist als der Referenzpegel, so daß im gegebenen Unterband eine von Null verschiedene Verstärkung vorhanden ist.

7. Vorrichtung nach Anspruch 6, **dadurch gekennzeichnet,** daß die Unterdrückungsmittel (P1 - P4) Rauschinformationssignale in einem gegebenen Unterband, die den Referenzpegel (Ref) überschreiten, mit einer Stärke unterdrücken, die umgekehrt proportional zur Überschreitung des Referenzpegels (Ref) durch die Rauschinformationssignale ist, und daß Rauschinformationssignalpegel (S). die eine obere Grenze (Max) überschreiten, im wesentlichen nicht unterdrückt werden.

8. Vorrichtung nach Anspruch 5, **dadurch gekennzeichnet,** daß sie eine Gleichrichtereinrichtung (10) und eine Tiefpassfiltereinrichtung (11) zur Bildung von Rauschinformationssignalpegeln (S) für jedes Unterband aufweist, daß Mittel zur Bestimmung eines Langzeitminimums (N) des Rauschinformationssignalpegels (S) vorhanden sind, der als Referenzpegel (Ref) verwendet wird, und daß die Unterdrückungsmittel (P1 - P4) eine Verstärkung (P) aufweisen, die bestimmt wird durch

$$P = \max \{(S - 2N) / S, C\},$$

worin S der Signalpegel, N das Langzeitminimum des Rauschinformationssignalpegels und C eine Konstante sind, die die Minimumverstärkung eines jeweiligen Unterbandes angibt.

9. Vorrichtung nach einem der Ansprüche 6 bis 8, **dadurch gekennzeichnet,** daß der Informationskanal einen Basisfrequenz-Sprachkanal für einen Kommunikationskanal aufweist und das Frequenzband des Kanals in vier Unterbänder (B1 - B4) unterteilt ist.

10. Vorrichtung nach einem der Ansprüche 6 bis 9, **dadurch gekennzeichnet,** daß Allpass-Filtermittel vorhanden sind, um ein Frequenzband des Informationskanals in die Unterbänder (B1 - B4) zu unterteilen.

**Revendications**

1. Procédé de suppression du bruit dans un canal d'information (1), comprenant le filtrage d'un signal d'information bruyant passant à travers le canal de telle sorte que la bande de fréquence du canal (1) soit divisée (CH1 à CH4) en sous-bandes (B1 à B4), la comparaison dans chaque sous-bande (B1 à B4), du niveau du signal d'information bruyant (S) avec un niveau de référence (Réf), la définition comme bruit d'un niveau du signal d'information bruyant égal ou inférieur au niveau de référence (Réf), et le déparasitage (P1 à P4) du dit signal d'information bruyant conformément à une courbe caractéristique donnée afin de former un signal déparasité puis la sommation des signaux déparasités dans chacune des sous-bandes (B1 à 84), caractérisé en ce que le déparasitage du dit signal d'information bruyant présente une valeur maximale telle que lorsque le niveau du signal d'information bruyant (S) dans une sous-bande donnée est égal ou inférieur au niveau de référence, le gain dans la sous-bande donnée est non-nul.

2. Procédé selon la revendication 1, dans lequel, lorsque le niveau du signal d'information bruyant (S) détecté dans une sous-bande excède le niveau de référence (Réf), son déparasitage est inversement proportionnel à la quantité en excès conformément à la courbe caractéristique donnée, et les niveaux du signal d'information bruyant excédant une limite supérieure (Max) sont pratiquement non éliminés.

3. Procédé selon la revendication 1, dans lequel, le niveau du signal d'information bruyant (S) devant être comparé dans une sous-bande donnée est effectué par redressement (10) puis filtrage passe-bas (11) du signal d'information bruyant, le niveau de référence (Réf) est formé comme minimum à long terme (N) du niveau du signal d'information bruyant, et le niveau du gain du signal (P) à tout instant donné est obtenu à partir de la formule :

$$P = max \{(S - 2N)/S , C\}$$

où S est le niveau du signal d'information bruyant, N est le minimum à long terme du niveau du signal d'information bruyant et C est une constante qui indique le gain minimum de la sous-bande respective.

4. Procédé selon l'une quelconque des revendications ci-dessus, dans lequel le canal d'information comprend, comme canal de communication, un canal conversationnel dont la fréquence est la fréquence de base et dont la bande de fréquences est divisée en quatre sous-bandes (B1 à B4).

5. Procédé selon l'une quelconque des revendications ci-dessus, dans lequel la bande de fréquences du canal est divisée en sous-bandes (B1 à B4) en utilisant un assemblage de filtres passe-tout.

6. Dispositif d'élimination du bruit dans un canal d'information (1), comprenant des moyens de filtrage pour diviser (CH1 à CH4) le signal d'information bruyant provenant du canal d'information en sous-bandes (B1 à 84), un moyen de comparaison dans chaque sous-bande (B1 à 84), pour la comparaison du niveau du signal d'information bruyant (S) avec un niveau de référence (Réf), des moyens de déparasitage (P1 à P4) pour déparasiter les signaux d'information bruyants dans les sous-bandes respectives (B1 à B4), conformément à une courbe caractéristique donnée, afin de former des signaux d'information bruyants déparasités, puis des moyens de sommation pour effectuer la sommation des signaux d'information bruyants déparasités dans chaque sous-bande (B1 à B4), caractérisé en ce que le moyen de déparasitage (P1 à P4) fonctionne à une valeur de déparasitage maximale lorsque le signal d'information bruyant dans une sous-bande donnée est égal ou inférieur au niveau de référence, de telle sorte que le gain dans la sous-bande donnée soit non-nul.

7. Dispositif selon la revendication 6, dans lequel le moyen de déparasitage (P1 à P4) est adapté pour déparasiter dans une sous-bande donnée les signaux d'information bruyants excédant le niveau de référence (Réf) d'une quantité qui est inversement proportionnelle à la quantité de laquelle les signaux d'information bruyants excèdent le dit niveau de référence (Réf), et dans lequel les niveaux des signaux d'information bruyants (S) excédant une limite supérieure (Max) sont pratiquement non éliminés.

8. Dispositif selon la revendication 6, dans lequel sont fournis un moyen redresseur (10) et un moyen de filtrage passe-bas (11) pour générer un niveau du signal d'information bruyant (S) dans chaque sous-bande, un moyen pour déterminer le minimum à long terme du niveau du signal d'information bruyant (N) pour utiliser celui-ci comme niveau de référence (Réf), et dans lequel le moyen de déparasitage (P1 - P4) possède un gain (P) donné par :

$$P = max \{(S - 2N)/S, C\}$$

où S est le niveau du signal, N est le minimum à long terme du niveau du signal d'information bruyant et C est une constante qui indique le gain minimum de la sous-bande respective.

9. Dispositif selon l'une quelconque des revendications 6 à 8, dans lequel le canal d'information comprend, comme canal de communication, un canal conversationnel dont la fréquence est la fréquence de base et dont la bande de fréquences est divisée en quatre sous-bandes (B1 à B4).

10. Dispositif selon l'une quelconque des revendications 6 à 9, dans lequel sont fournis des moyens de filtres passe-tout pour diviser la bande de fréquences du canal d'information en sous-bandes (B1 à B4).

FIG. 1

FIG. 2

7

FIG. 3

FIG. 4

FIG. 5

FIG. 6